# EUROPEAN PATENT APPLICATION

(11) **EP 2 843 780 A1**
(43) Date of publication of application: **04.03.2015**
(21) Application number: 14182361.7
(22) Date of filing: 27.08.2014
(51) Int. Cl.: H01R 43/16, B23K 15/00, H01J 37/305

(54) **Electron-beam-supported production of electrical components**

(30) Priority: 27.08.2013 DE 102013217068
(71) Applicant: Tyco Electronics AMP GmbH, 64625 Bensheim (DE)
(72) Inventor: Schmidt, Helge, 67346 Speyer (DE); Henschel, Eva, 47058 Duisburg (DE); Sachs, Soenke, 60385 Frankfurt am Main (DE)
(74) Representative: Grünecker, Kinkeldey, Stockmair & Schwanhäusser

(57) **Abstract**

The invention relates to a method (V) for producing at least one electrical component (1), in particular a contact element (2), comprising the method steps of separating, at least partially hardening and/or at least partially softening the electrical component (1), and an electrical component (1) produced in this manner and a device (7) for producing electrical components (1). An object of the invention is to provide a method (V) for producing at least one electrical component (1) which is more simple and cost-effective than conventional methods. This object is achieved in that at least one of the method steps mentioned is carried out with an electron beam (4). An electrical component (1) according to the invention was produced using a method (V) according to the invention. A device (7) according to the invention for producing electrical components (1) is constructed in order to carry out the method (V) according to the invention.

## Description

The invention relates to a method for producing at least one electrical component, in particular a contact element for a plug type connector, comprising the method steps of separating and/or at least partially hardening and/or at least partially softening the electrical component. Furthermore, the invention relates to an electrical component, in particular a contact element, which has been produced with such a method. The invention further relates to a device for producing electrical components, in particular contact elements.

The production of electrical components, such as, for example, contact elements for plug type connectors, is often complex and cost-intensive and inflexible since a separate tool is required for each layout.

An object of the invention is to provide a method for producing at least one electrical component, in particular a contact element, which is more flexible, more versatile and more cost-effective than conventional methods.

This object is achieved in that at least one of the method steps mentioned is carried out with an electron beam. An electrical component according to the invention was produced with a method according to the invention. A device according to the invention for producing electrical components, in particular contact elements, is constructed in order to carry out the method according to the invention.

Electron beams are easy and cost-effective to produce and simple to control. The method thereby becomes more cost-effective and less complex.

The solution according to the invention can be further improved with the following developments and embodiments which are each advantageous per se and which may be freely combined with each other.

The electrical component may partially or completely comprise metal. The electrical component may have one or more coatings. These may be used, for example, to improve the production of the connection or for protection from external influences and corrosion. They may be applied, for instance, by means of a metal-plating process, by means of an immersion process or by means of another coating method.

The electrical component may be at least partially separated from a base member by means of an electron beam, in particular it may be cut with the electron beam. Electrical components, such as contact elements, are often produced from metal sheets. To this end, the profiles and the function-relevant holes are punched from the metal sheet. It is disadvantageous in this instance that a specific minimum spacing between two cutting faces has to be maintained. For example, the rule of thumb is that a punched hole may not be smaller than the material thickness. The further development towards smaller dimensions is thereby limited since the effects which occur when punching inner components and small components, such as bending of the component, can be controlled only with difficulty. In contrast, with an electron beam, very small holes and cutting faces may be produced with small spacing with respect to each other. In contrast to in a punching process, the component is not bent. Furthermore, it is not necessary to produce a suitable die and a punch, whereby the method is more cost-effective. A tool change can also be dispensed with. A cutting template can be selected in a flexible manner, for example, by means of a piece of software. The electron beam may be placed with a high degree of selectivity and a high degree of precision in the region of a few µm. The width of a cutting gap may be less than 50 µm.

The electrical component may be cut from a strip material. Production is thereby possible with continuous sheeting, such as, for example, a continuous method or an intermittent method. An elongate metal sheet may be considered, for example, as the material.

In an advantageous embodiment, all the separation and cutting processes during the production are carried out with an electron beam. The production of dies and punches can be completely dispensed with. The method is thereby very cost-effective.

With the method according to the invention, different electrical components can be produced. In contrast to the example with a punching method, relatively thick electrical components can also be cut with comparatively little effort. For example, cables with or without insulation may be shortened or shielding elements may be cut. Owing to the fact that the electron beam can be easily controlled, the method can be used in a variable manner. In particular, the production of individual pieces or small batches is also possible and cost-effective since, in comparison with the punching method, no specific tools have to be produced. It is particularly advantageous for the method for producing contact elements to be used since contact elements can be produced in a cost-effective manner with a large number of possible embodiments.

The electrical component can be chemically changed by means of the electron beam. For example, it can be reduced by the striking electrons. Atoms or molecules can be ionised and form new bonds. A chemical change is also possible as a result of the heat development which occurs. The electrical component may thereby, for example, be more resistant or easier to contact.

The electrical component may be physically changed, at least in the cutting region. For example, edges in the cutting region may be rounded with the electron beam. The edges may thereby cause less damage, for example, in additional process steps. Furthermore, in the cutting region, by changing the material structure, a hardening or a softening action may take place, depending on how and with what degree of intensity the electron beam acts. Contact production can thereby be improved, for example, by means of a higher degree of torsional rigidity.

In an advantageous embodiment, the electron beam is used to weaken or soften portions of the electrical component. Previously, in particular with hard materials, problems occur in the bending process, in particular when the electrical components are very small since they break easily and only a large bending radius can be achieved. Owing to the solution according to the invention, it is also possible to use hard materials. For example, before the cutting operation, specific regions which are later intended to be bent can be selectively softened by means of the electron beam. This may be achieved, for instance, by an electron beam acting on the region over a relatively long period of time and thereby heating the region and surrounding regions. Owing to the extensive heating, the subsequent cooling process is carried out in a relatively slow manner and the material in this region has sufficient time to move approximately into an equilibrium phase. In the approximate equilibrium phase, comparatively large phase ranges and few grain boundaries may be present. This region may thereby be softer than surrounding regions and can be more easily bent. The risk of material damage, such as breakages or cracks, is reduced. Such regions may, for instance, be line-like or linear or also planar. The softening can take place before or after a cutting step.

In a particularly advantageous embodiment, the electrical component is plastically deformed after the softening at a portion, for example, bent or folded.

The electron beam can be used to harden portions of the electrical component. Such regions may, for example, be regions which later have to be particularly stable and robust, for instance, since they are contacted and are subjected to impacts. The hardening can also be used to increase the resilient force in soft and/or thin regions and thereby to enable, for example, better contacting. In previous methods, in order to achieve relatively high resilient forces, costly special alloys or complex product designs are used. In order to harden a region according to the invention, the electron beam may be directed, for example, only briefly and at high intensity onto the region. During the short and intensive heating, the heat which is produced can hardly flow away into surrounding regions. If the electron beam is switched off, the heat which is present in the region owing to the large temperature difference is quickly discharged to the surrounding regions. The material hardly has time in this region to move into an approximate equilibrium phase. The irregular structure present is frozen by the rapid cooling process. The material at this location is then particularly hard. In an advantageous embodiment, a region is softened in a first step, then bent and subsequently hardened.

In an advantageous embodiment, the electron beam is used for structuring at least portions of the surface of the electrical component. The surface may, for example, be structured. With such a structured surface, an improvement of the contacting can be achieved. Furthermore, it is possible to write on the surface with an electron beam, for example, in order to apply a type designation. Using the electron beam, point-like, linear and planar regions may therefore be structured.

The electron beam can be used to produce a functional region by remelting a material layer which has been applied. Such a material layer may, for example, be printed. It may be a metal dye. Owing to the remelting, the material layer can be connected to the electrical component. The functional region produced may, for example, be used for contacting or for protection. The electron beam which is used for remelting can subsequently also be used for cutting.

The method steps described can be carried out independently of each other in each case. An electrical component may, for example, be only cut, only hardened or only softened with the electron beam.

In an advantageous embodiment of the method, a plurality of method steps are carried out with an electron beam in order to be able to carry out production in a particularly cost-effective manner. For example, one electron beam is used for softening, cutting and hardening.

In a particularly advantageous embodiment, an electron beam is used for remelting an applied material layer, for weakening a region which is intended to be bent, for cutting and subsequently hardening a region. In this instance, the electrical component may be in a fixed state. Instead, the electron beam moves.

In another advantageous embodiment of a combined method which has been mentioned above, the electrical component which is, for example, part of a moving strip, moves. In the different stations, different electron beam sources can be used. A higher productivity can thereby be achieved than when a single electron beam source is used.

Advantageously, the method according to the invention is operated under vacuum, in particular under high vacuum, for example, in a range < 10⁻³ mbar. In this instance, the entire production method does not have to take place under vacuum. It is also possible to carry out only the method steps which are carried out with the electron beams under vacuum.

Advantageously, using the method according to the invention, it is also possible to process free-standing or non-supported portions of the electrical component. For instance, portions of an electrical component which have already been bent can thus be cut. In a punching method, this is not possible or is possible only with great difficulty. Hardening or softening can also be carried out on free-standing or non-supported portions.

Since the electron radiation involves particle radiation, the maximum of the absorbed energy is located not on the surface but instead inside the material. By means of variation of the electron energy, via the acceleration voltage, the penetration depth of the electrons into the material can be adjusted in a selective manner. It is thereby possible to selectively harden or soften mainly regions close to the surface, but also deeper regions.

An electrical component according to the invention is produced with a method according to the invention. Since the depth at which the highest energy transmission from the electrons to the atoms of the material of the electrical component takes place can be adjusted in a variable manner, the main active region may be located, for example, at the centre of an electrical component, for example, a metal sheet, and the heat development required to harden, soften or cut may originate from such a central region. On a completed electrical component, the location of the greatest heat development may, for example, be established on the basis of the grain structure or the chemical and/or physical properties at various positions. Even chemical changes which are brought about by the electron beam, such as, for example, a reduction or an oxidation, can be identifiable in such electrical components. In the region which is processed with the electron beam, for example, in the edge or cutting region, chemical or physical properties can be changed in comparison with regions which are not processed, such as internal regions.

In particular, an electrical component may have edges which are cut by an electron beam. In comparison with a punching method, the method according to the invention produces with a cutting step no punched edges or deformations which are brought about by punching. This can be established in a complete electrical component.

An electrical component according to the invention may be characterised in that it is at least partially electron-beam softened.

An electrical component according to the invention may be characterised in that it is at least partially electron-beam hardened.

A device according to the invention is constructed in order to carry out the method according to the invention. It may comprise at least one cutting module, which is configured for cutting with an electron beam. It may comprise at least one hardening module which is configured for hardening with an electron beam. It may comprise at least one softening module which is configured for cutting with an electron beam.

The invention is explained in greater detail below by way of example with reference to advantageous embodiments and the drawings. The embodiments illustrated constitute only possible configurations in which features explained in the individual embodiments may be freely combined with each other and omitted, as desired in the individual application case.

In the drawings:
Figure 1 is a schematic illustration of a first embodiment of a method according to the invention;
Figure 2 is a schematic illustration of a second embodiment of a method according to the invention;
Figure 3 is a schematic illustration of the principle of the method from Figure 2;
Figure 4 is a schematic illustration of a component according to the invention, which has been processed with the method according to Figure 2;
Figure 5 is a schematic illustration of a third embodiment of a method according to the invention;
Figure 6 is a schematic illustration of the principle of the method from Figure 5;
Figure 7 is a schematic cross-section of the heat distribution which occurs in the method according to Figure 5;
Figure 8 is a scanning electron microscope image of a material which has been processed using the method according to Figure 5;
Figure 9 is a schematic illustration of a fourth embodiment of a method according to the invention.

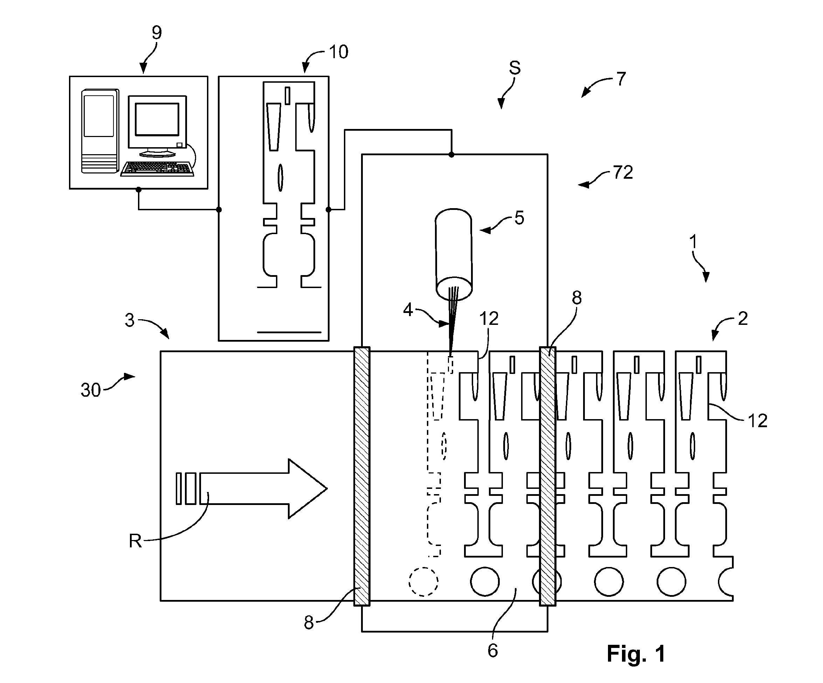

Figure 1 shows a first embodiment of a method V according to the invention for producing at least one electrical component 1. The electrical component is a contact element 2. There is shown the method step in which contact elements 2 are at least partially separated from a base member 30, in particular cut. Before this cutting step S is carried out, a strip material 3 which in this instance constitutes the base member 30 is still continuous and has no cuts at the inner side. In the cutting step S illustrated in the centre, a large number of contact elements 2 are at least partially separated from the continuous strip material 3 using an electron beam 4.

The electron beam 4 originates from an electron beam source 5 which, in addition to an electron source, may also have acceleration elements, focusing elements and redirection elements. However, these are not shown in detail owing to the schematic illustration.

The electron beam 4 can be used to cut the outer contours, but also to cut closed holes in the inner side which are not accessible from the outer side. Since the electron beam can be redirected very rapidly, high cutting speeds of up to 4000 mm/s and more are possible. In this instance, the position of the electron beam can be adjusted precisely to a few µm. In this instance, the beam may have a diameter of less than 100 µm. A typical output power of an electron beam is from 50 to 5000 Watt. In this instance, the electrons are accelerated with an acceleration voltage of from 20 to 150 kV. Depending on the installation and application purpose, the values mentioned may be increased or decreased.

In the method V shown, the strip material 3 may pass through the process at a continuous speed or be moved gradually. In this instance, an adaptation of the redirection of the electron beam 4 to the travel speed of the strip material 3 at which it travels in the displacement direction R may then be required.

When the cutting step S is carried out, the strip material 3 is in a vacuum 6. This is a high vacuum, in which there is a pressure < 10⁻³ mbar. Outside the region of the vacuum 6, there is normal pressure. In order to be able to convey the strip material from normal pressure into the vacuum and after processing to normal pressure again, the device 7 has high vacuum cascade arrangements 8 which are illustrated only schematically. These enable the pressure to be reduced and increased again in several stages.

Figure 1 is also a schematic illustration of a control system having a computer 9. This computer 9 passes a pattern 10 to be cut to a cutting module 72. This pattern 10 is subsequently cut from the strip material 3.

The strip material may, for example, be a metal sheet. This may already be coated, for example, by means of a metal-plating process.

After the cutting step 72 shown in Figure 1, further process steps may be carried out. For example, a contact element 2 may be definitively separated from the strip material 3 in another step. This may be carried out, for example, by means of breaking, punching or cutting. However, since the contact element 2 is still transported before being connected, for example, to a cable, it is still located after the cutting step S on the strip material 3 in order to enable simple storage and simple transport.

Owing to the electron beam 4, edges 12 may be rounded in the cutting region. This may be carried out automatically by melting material and/or in a selective manner by controlling the electron beam 4. Such edges 12 may lead to less damage than non-rounded edges 12.

Owing to the electron beam 4, the electrical component 1 can be chemically and/or physically changed, at least in the edge region and/or cutting region. For example, the material at this location can be oxidised or reduced. A change of the hardness and/or the grain structure may occur in the cutting region. Regions which have been processed with the electron beam may have different chemical and/or physical properties from regions which have not been processed.

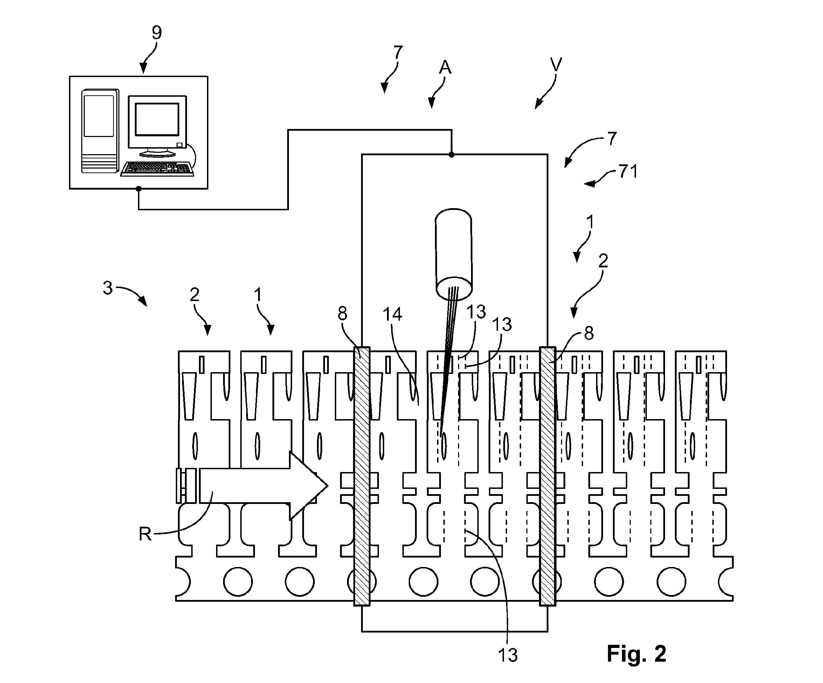

Figure 2 shows a second embodiment of a method V according to the invention. There is shown in this instance a softening step A, in which portions 13 of the electrical component 1 are softened in a selective manner by means of the electron beam 4. To this end, the device 7 has a softening module 71. The portions 13 are linear portions. At the portions 13, after the softening step A, the contact elements 2 can be more readily folded and/or bent. In a similar manner to the method in Figure 1, other methods steps can be carried out before and after the method step shown. Figure 2 shows, for example, that the strip material 3 has already been partially cut into contact elements 2 before it is softened at the portions 13.

In order to control the electron beam 4, a computer 9 is used again. Furthermore, the device 7 shown again has high pressure reduction cascade arrangements 8 which isolate the processing region 14 from the environment in terms of pressure. Since the strip material 3 passes through the processing region 14, there are provided in the high pressure reduction cascade arrangements 8 slots through which the strip material 3 travels.

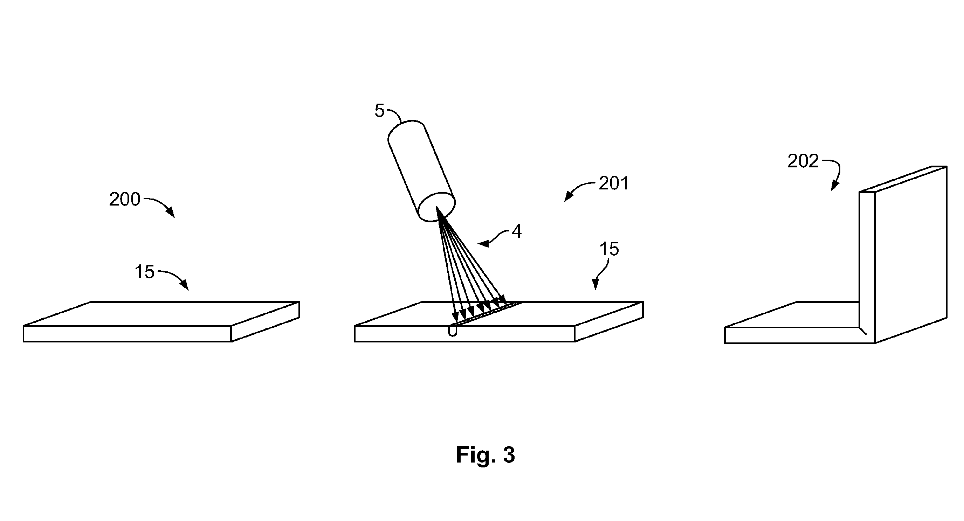

In Figure 3, the principle of the method V from Figure 2 is illustrated in a simplified manner. The material 15 to be processed is still unprocessed in the method step 200 illustrated on the left. In the method step 201 illustrated at the centre, the material 15 is processed in a linear region with an electron beam 4. In this instance, a point-like electron beam 4 can be moved over the sample or a linear electron beam 4 can be used. The electron beam 4 has a comparatively low intensity and a long reaction time. The heat which is produced in the linear region is thereby discharged into adjacent regions. After the electron beam 4 has been turned off, the linear region therefore slowly cools. The material structure may in this region become close to a state of equilibrium. In such a state, comparatively few grain boundaries are present. The material 15 is thereby soft at this location. In the method step 202 illustrated at the right-hand side, the material 15 can therefore be slightly bent at the linear softening.

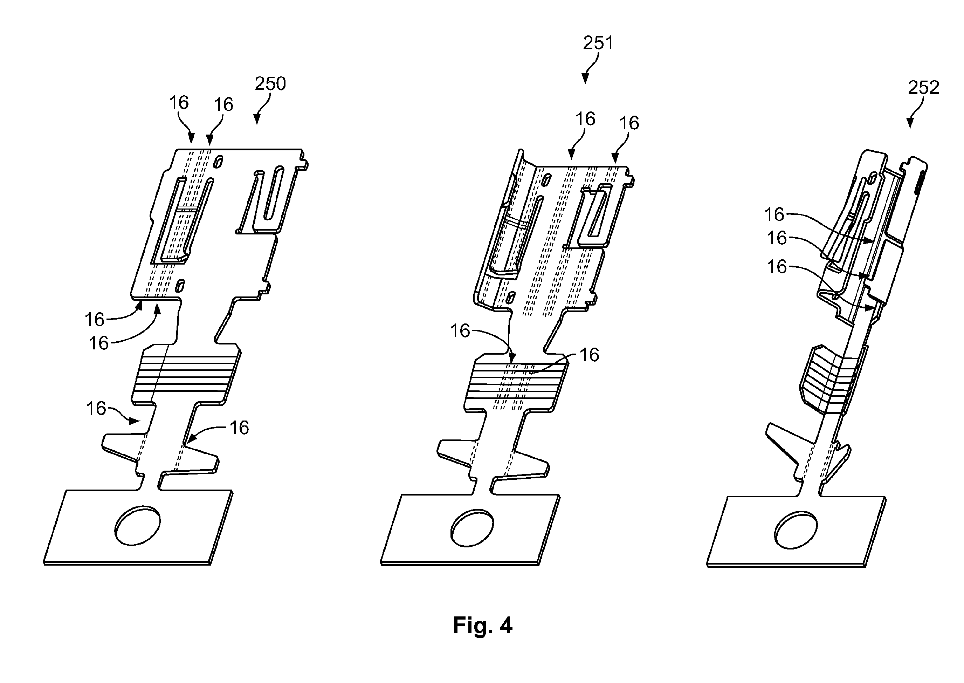

Figure 4 illustrates a contact element 2 which has been produced using the method from Figures 2 and 3 in subsequent method steps. In the left-hand method step 250, the contact element 2 already has fold edges 16 which have been softened by the method V. In the method step 251 illustrated in the centre, the contact element 2 has been bent at the fold edges 16 which are already present. Furthermore, additional fold edges 16 have been produced by an electron beam 4 being moved over the contact element at other locations. In the method step 252 illustrated at the right-hand side, the contact element was finally also bent at the fold edges 16 which have been further added. Of course, all the fold edges 16 can also be softened before they are bent in one or more subsequent steps.

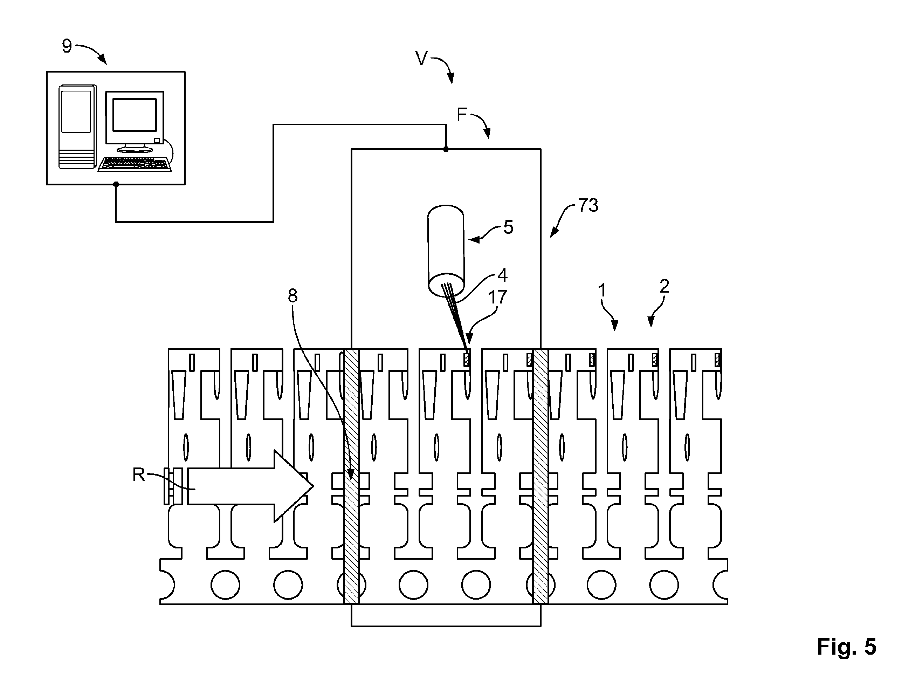

Figure 5 illustrates a third embodiment of a method V according to the invention. Only a hardening step F is shown. In this hardening step F, an electron beam 4 is used to harden a portion 17. The device additionally has a hardening module 73. A portion 17 may, for example, be a portion which is subjected to the impact of engagement operations when the contact element 2 is used. The hardening step F can also be used only to increase the resilient force in the region 17. This may, for instance, be relevant if particularly small contact elements 2 are produced. Contacting may be more difficult therein since the material does not have a very high degree of resilient force owing its thin construction. Owing to the hardening step F, the resilient force can be increased and better contacting can thereby be ensured. In another embodiment, a hardening step can also be carried out after a softening step A, as illustrated in Figure 2, in the softened portion 13, after, for example, the contact element 2 has been bent at the portion 3.

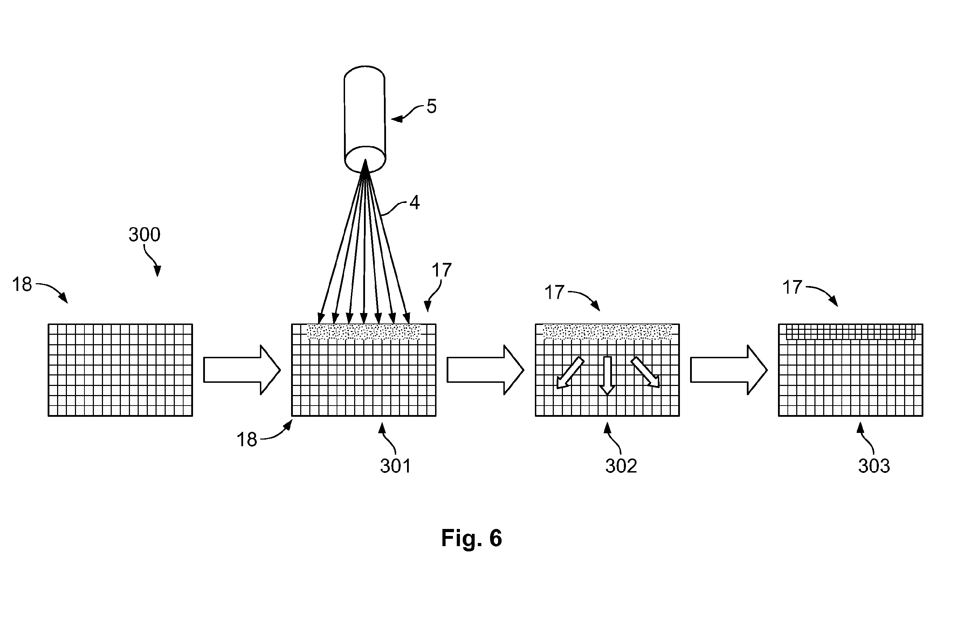

Figure 6 is a schematic illustration of the physical processes which occur during the hardening step F. In the first method step 300, the material 18 to be processed is still unprocessed. In the second method step 301, a portion 17 of the material 18 is processed with an electron beam 4. The electron beam 4 is in this instance very intensive and the reaction time is very short. The portion 17 is thereby heated very rapidly, but the surrounding regions hardly at all. In the third method step 302, the heat produced in the portion 17 is rapidly discharged to the adjacent regions owing to the high temperature gradient. The portion 17 therefore cools very significantly and very rapidly. The material cannot thereby change into a state of equilibrium in the portion 17, but instead is frozen in a relatively unstructured state. It has many grain boundaries in this region. The material in the portion 17 is therefore very hard.

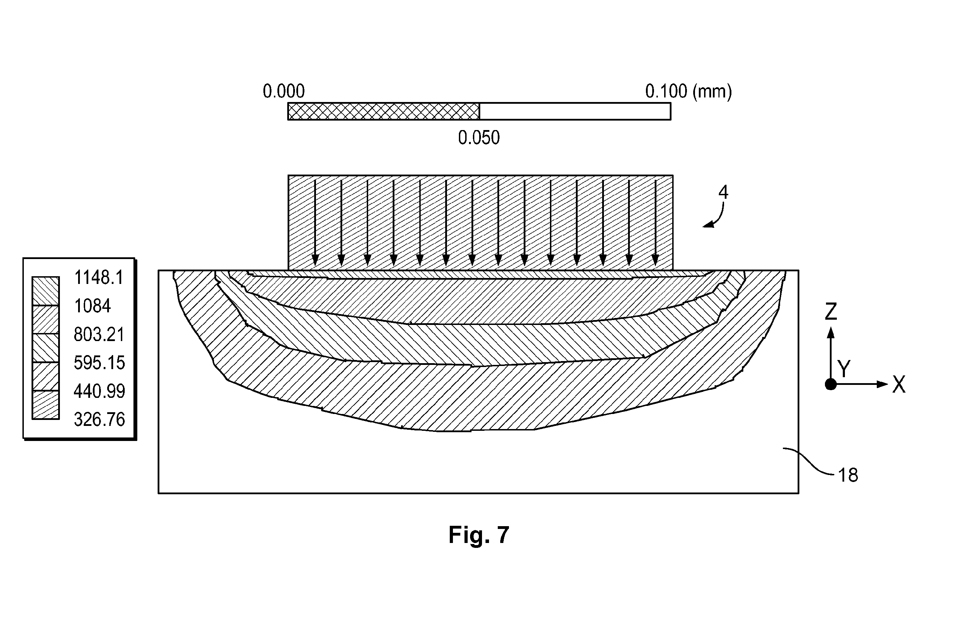

Figure 7 shows a simulation which shows the heat distribution of the temperature to which action of an electron beam 4 on a material 18 leads. The material is a copper alloy. The beam diameter is 100 µm, the electron beam energy 175 W and the reaction time 12 µs. Directly at the surface, the material 18 is melted. In the adjacent region, temperatures are approximately 1100°C. Owing to the very intensive and short electron beam, however, temperatures are only approximately 300°C only a few 10 µm away. The heat transfer is therefore carried out in a very local and concentrated manner. It is ensured that the heat which is produced owing to the high temperature gradient can be rapidly discharged to the surrounding regions and the irradiated region is very rapidly cooled. The rather disorderly grain structure resulting from the high temperature is therefore frozen and the material has many grain boundaries at that location. It is thereby very hard and stable.

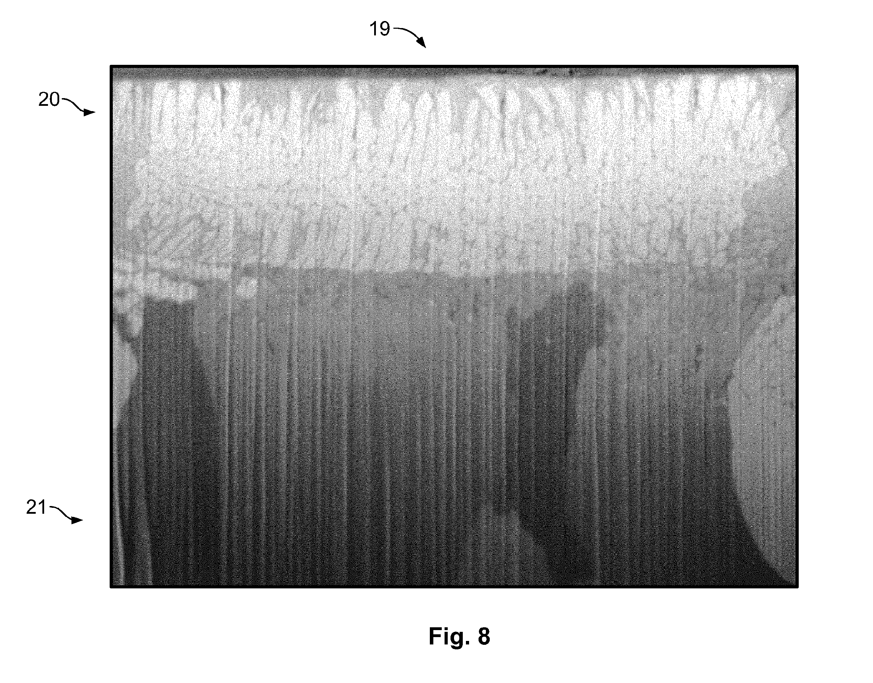

Figure 8 shows a cut through a material which has been processed with electron beams. The cut was in this instance carried out by means of a focused ion beam (FIB). The picture is an image from a scanning electron microscope. In the upper region 20 which is adjacent to a surface 19, the material has an increased number of grain boundaries. In the lower region 21, which has not been heated so significantly, however, there are fewer grain boundaries. The upper region 20 is harder compared with the lower region 21.

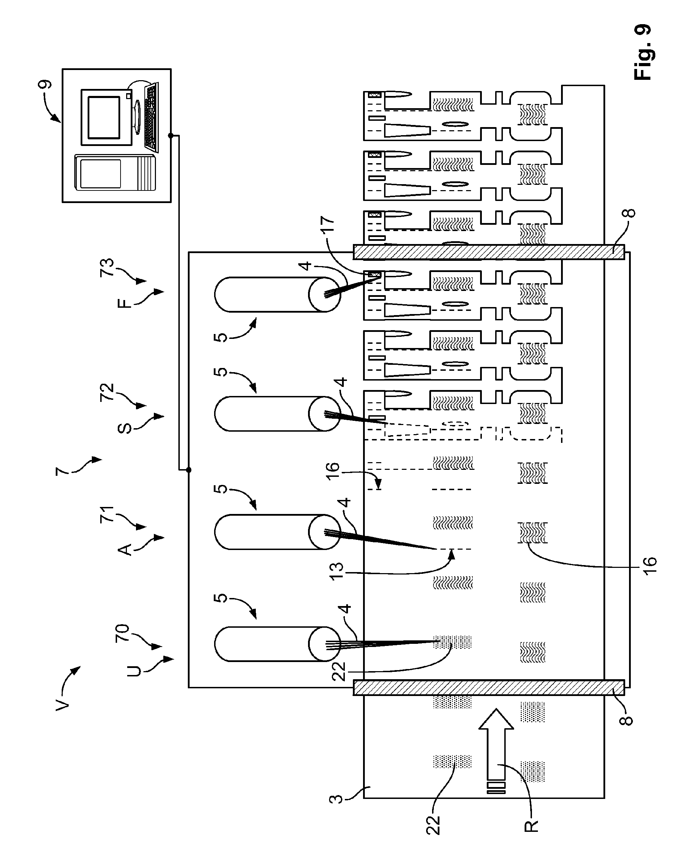

Figure 9 illustrates a particularly preferred embodiment of a method V. The method V comprises the method steps which are already illustrated. In addition, it also comprises a remelting step U, in which material which has been applied to the strip material 3 in the form of a metal dye 22 is melted. Alternatively, another material can also be applied to the strip material 3 for remelting. This may, for example, be sprayed on or applied as a powder.

In the subsequent softening step A, portions 13 are softened and fold edges 16 are thereby produced. In the cutting step S, the contours and inner regions which are intended to be free-standing are cut with the electron beam 4. Afterwards, other portions 17 are hardened with the electron beam 4 in the hardening step F. In these four method steps, four different electron beam sources 5 are used in order to achieve the highest possible level of productivity. In an alternative embodiment, it is also possible to use only a single electron beam source 5 for all the method steps U, A, S, F. Since the electron beam can be redirected very easily and very rapidly with electrical and/or magnetic fields, no significant pauses are required between the individual method steps.

In the method V illustrated in Figure 9, the strip material 3 can be moved continuously in the movement direction R. The electron beams 4 move with the strip material. The movement of the electron beams 4 and also the other parameters and the cutting patterns are again calculated and controlled by a computer 9.

The device 7 shown therefore comprises a remelting module 70, a softening module 71, a cutting module 72 and a hardening module 73. In particular, the softening module 71 is constructed for softening with an electron beam 4. Furthermore, the cutting module 72 is constructed for cutting with an electron beam 4. The hardening module 73 is also constructed for hardening with an electron beam 4. Finally, the remelting module 70 is also constructed for remelting with an electron beam 4.

The method shown in Figure 9 can also be carried out in a different sequence. For example, the strip material 3 can first be cut and the portions 13 subsequently softened. The hardening is also not necessarily carried out after the cutting, but instead can also be carried out before the cutting. In an advantageous embodiment, portions 13 which are softened in the softening step A are hardened again in a subsequent hardening step F in order to ensure sufficient stability and resilient force.

The method steps shown can also be carried out only individually with an electron beam 4. For example, an electrical component 1 can be cut using only an electron beam 4 and can be softened and hardened in a different manner. The same applies to softening and hardening. Of course, not all the method steps also have to be carried out during the production of an electrical component. During the production, it is possible, for example, to carry out only one cutting step, but no softening or hardening step.

In a method step which is not shown, an electron beam 4 could also be used to structure a surface. It could cut only partially into the surface and thereby score and/or roughen the surface. Lettering using an electron beam 4 is also conceivable.

### List of reference numerals

- 1: Electrical component
- 2: Contact element
- 3: Strip material
- 4: Electron beam
- 5: Electron beam source
- 6: Vacuum
- 7: Device
- 8: High vacuum cascade arrangement
- 9: Computer
- 10: Pattern
- 12: Edges
- 13: Portion
- 14: Processing region
- 15: Material
- 16: Fold edge
- 17: Portion
- 18: Material
- 19: Surface
- 20: Upper region
- 21: Lower region
- 22: Metal dye
- 30: Base member

- 70: Remelting module
- 71: Softening module
- 72: Cutting module
- 73: Hardening module

- 200 to 202: Method steps
- 250 to 252: Method steps
- 300 to 303: Method steps
- A: Softening step
- F: Hardening step
- R: Movement direction
- U: Remelting step
- S: Cutting step

## Claims

1. Method (V) for producing at least one electrical component (1), in particular a contact element (2) for a plug type connector, comprising the method steps of separating and/or at least partially hardening and/or at least partially softening the electrical component, **characterised in that** at least one of the method steps mentioned is carried out with an electron beam (4).

2. Method (V) according to claim 1, **characterised in that** the electrical component (1) is a contact element (2).

3. Method (V) according to claim 1 or claim 2, **characterised in that** the electrical component (1) is at least partially separated from a base member (30) by means of an electron beam (4).

4. Method (V) according to claim 3, **characterised in that** the electrical component (1) is cut from a strip material (3).

5. Method (V) according to claim 3 or 4, **characterised in that** all the cutting processes are carried out with an electron beam (4).

6. Method (V) according to any one of claims 1 to 5, **characterised in that** the electron beam (4) is used to soften portions (13) of the electrical component (1).

7. Method (V) according to claim 6, **characterised in that** the electrical component (1) is subsequently plastically deformed at the softened portion (13), in particular bent.

8. Method (V) according to any one of claims 1 to 7, **characterised in that** the electron beam (4) is used to harden at least portions (17) of the electrical component (4).

9. Method (V) according to claim 7 and claim 8, **characterised in that** the electrical component (1) is hardened by means of an electron beam (4) in the portion (13) softened and subsequently plastically deformed by means of the electron beam (4).

10. Electrical component (1), in particular a contact element (2), **characterised in that** it is produced with a method (V) according to any one of claims 1 to 9.

11. Electrical component (1) according to claim 10, **characterised in that** regions which have been processed with the electron beam (4), in particular edge regions and cutting regions, have different chemical and/or physical properties from unprocessed regions.

12. Device (7) for producing electrical components (1), **characterised in that** it is constructed in order to carry out a method (V) according to any one of claims 1 to 9.

13. Device (7) for producing electrical components (1) according to claim 12, **characterised in that** it comprises at least one cutting module (72) which is configured for cutting with an electron beam (4).

14. Device (7) for producing electrical components (1) according to claim 12 or claim 13, **characterised in that** it comprises at least one hardening module (73) which is configured for hardening with an electron beam (4).

15. Device (7) for producing electrical components (1) according to any one of claims 12 to 14, **characterised in that** it comprises at least one softening module (71) which is configured for softening with an electron beam (4).

16. Device (7) for producing electrical components according to any one of claims 12 to 15, **characterised in that** the device (7) has a single electron beam source (5) which is constructed for use in a plurality of the method steps of cutting, hardening and softening, preferably in all the method steps.
